(19)

Europäisches
Patentamt
European
Patent Office
Office européen
des brevets

(11)     **EP 1 876 276 A1**

(12)     **EUROPEAN PATENT APPLICATION**
published in accordance with Art. 153(4) EPC

(43) Date of publication:
     **09.01.2008 Bulletin 2008/02**

(51) Int Cl.:
     ***D04H 3/00*** (2006.01)     ***D04H 3/16*** (2006.01)
     ***D01F 9/145*** (2006.01)     ***D21H 13/50*** (2006.01)
     ***C08J 5/04*** (2006.01)

(21) Application number: **06732178.6**

(22) Date of filing: **14.04.2006**

(86) International application number:
     **PCT/JP2006/308370**

(87) International publication number:
     **WO 2006/112516 (26.10.2006 Gazette 2006/43)**

(84) Designated Contracting States:
     **AT BE BG CH CY CZ DE DK EE ES FI FR GB GR
     HU IE IS IT LI LT LU LV MC NL PL PT RO SE SI
     SK TR**

(30) Priority:   **19.04.2005   JP   2005120944
                 30.05.2005   JP   2005156893
                 21.09.2005   JP   2005273494
                 21.09.2005   JP   2005273495**

(71) Applicant: **TEIJIN LIMITED
     Osaka-shi
     Osaka 541-0054 (JP)**

(72) Inventors:
     • **HARA, Hiroshi,
       Iwakuni Res. Center,
       Teijin Ltd
       Iwakuni-shi,
       Yamaguchi 7400014 (JP)**

     • **HIRATA, Masumi,
       Iwakuni Res. Center,
       Teijin Ltd
       Iwakuni-shi,
       Yamaguchi 7400014 (JP)**
     • **BAN, Tetsuo,
       Iwakuni Res. Center,
       Teijin Ltd
       Iwakuni-shi,
       Yamaguchi 7400014 (JP)**

(74) Representative: **Hallybone, Huw George et al
     Carpmaels and Ransford
     43-45 Bloomsbury Square
     London WC1A 2RA (GB)**

(54)     **CARBON FIBER COMPOSITE SHEET, USE OF THE SAME AS HEAT TRANSFERRING
         ARTICLE, AND SHEET FOR PITCH-BASED CARBON FIBER MAT FOR USE THEREIN**

(57)     A carbon fiber composite sheet comprising a pitch-based carbon fiber web and a matrix resin, wherein carbon fibers constituting the pitch-based carbon fiber web have a crystallite size in the hexagonal net plane direction of 5 nm or more and a thermal conductivity in the thickness direction of 1 W/(m·K) or more.

This carbon fiber composite sheet is used for radio shielding and heat conduction.

Fig. 1

**EP 1 876 276 A1**

**Description**

TECHNICAL FIELD

The present invention relates to a carbon fiber composite sheet comprising a pitch-based carbon fiber web, use thereof as a heat conductor, and a carbon fiber sheet for the pitch-based carbon fiber web.

BACKGROUND ART

High-performance carbon fibers can be classified into PAN-based carbon fibers obtained from polyacrylonitrile (PAN) and pitch-based carbon fibers obtained from pitches. Carbon fibers are widely used in aviation and aerospace, construction and civil engineering, and sport and leisure applications, making use of their feature that they have much higher strength and elastic modulus than ordinary synthetic polymers.

While much attention is now paid to methods for making efficient use of energy, typified by energy saving, the generation of Joule heat from high-speed CPU's and electronic circuits is becoming an issue. To solve these, the efficient processing of heat, so-called "thermal management" must be attained.

Although carbon fibers have a higher thermal conductivity than ordinary synthetic polymers, the further improvement of thermal conductivity is now under study. Commercially available PAN-based carbon fibers generally have a thermal conductivity lower than 200 W/(m·K) and it is hardly said that they are preferred from the viewpoint of thermal management. In contrast to this, it is perceived that pitch-based carbon fibers easily attain a higher thermal conductivity than PAN-based carbon fibers.

As thermal conductive fillers, there are known fillers containing a metal oxide, metal nitride, metal carbide or metal hydroxide such as aluminum oxide, boron nitride, aluminum nitride, magnesium oxide, zinc oxide, silicon carbide, quartz or aluminum hydroxide. However, metal material-based fillers have high specific gravity and a large weight in the case of composite materials thereof. With regard to this, carbon fibers have an advantage that they have low specific gravity and can reduce the weight of a composite material when they are added in the same volume as a metal material-based filler.

To make effective use of the high thermal conductivity of the carbon fibers, it is preferred that the carbon fibers form a network while a matrix is existent among them. When the network is formed three-dimensionally, the high thermal conductivity of the carbon fibers is attained not only in the in-plane direction of a molded product but also in the thickness direction of the molded product, which is considered to be extremely effective for application in radiator plates. Although a composite material composed of a fabric formed of conventionally used fibers and a matrix has an improved thermal conductivity in the in-plane direction, it is hard to say that its thermal conductivity in the thickness direction is satisfactory because carbon fibers cannot form a network fully.

Under the above situation, many attempts have been made to improve the thermal conductivity of the carbon fibers drastically. JP-A 5-17593 discloses a thermal conductive molded article having high mechanical strength which is manufactured by impregnating carbon fibers drawn in one direction with graphite powders and a thermosetting resin. JP-A 2-242919 discloses that physical properties such as thermal conductivity are enhanced by the improvement of the physical properties of carbon fibers but is silent about the improvement of the thermal properties of a molded product.

Further, while much attention is now paid to methods for making efficient use of energy, typified by energy saving, as described above, radio waves generated from high-speed CPU's and electronic circuits is becoming an issue. Electrons moving through a circuit at a speed in the order of GHz emit radio waves having a frequency corresponding to their moving speed to the outside of the circuit. Therefore, they cause a problem such as a drift of electrons within the circuit or a speed reduction. Especially in a device having a plurality of functional circuits integrated thereon, how to cut mutual interference between radio waves is becoming a serious problem to be solved. Further, mobile communication equipment are now oriented toward communication with radio waves having a higher frequency so as to improve their communication speed. That is, radio waves and electrons move at almost the same frequency inside and outside a device, whereby interference by radio waves from the outside or the entry of noise into communication signals by radio waves generated from the inside of a circuit is becoming a very serious problem. In addition, the UHF band will be made open to the public due to the digitization of TV broadcasting, and the radio waves of the UHF band to be used have a shorter wavelength than those of the conventionally used VHF band. Therefore, though diffractivity and directivity become better, interference caused by structures such as buildings becomes a problem inevitably and a solution to this is required. Further, since the frequency of radio waves used for mobile communication is close to the frequency of the above radio waves, interference between them is becoming more serious, and it is important that the radio wave environment from circuits to structures such as buildings should be prepared.

To solve these problems, it is necessary to suppress the emission of radio waves from the inside of a circuit and the entry of radio waves from the outside of a circuit and improve the radio wave environment by cutting radio wave interference from structures.

Carbon materials have a significantly high electric conductivity as compared with ordinary synthetic polymers which are mostly insulators. Further, they have high strength and unique properties as a polymer. Therefore, the carbon materials are used not only in reinforcing materials but also in applications making use of their electric conductivity. It is expected that the frequency distribution of the dielectric constant of the carbon material is existent at a GHz range when the amount of free electrons estimated from electric conductivity is taken into consideration.

As means of cutting off radio waves generated from electronic circuits or radio waves used for communication, absorption or reflection by a magnetic material having electromagnetic interaction is well known. Therefore, existing radio wave absorbers often comprise a hard or soft material such as ferrite or permalloy as the magnetic material. To reduce the weight of a device, optimal balance between radio wave absorption and weight must be designed for a material having high density such as a metal or metal oxide.

Meanwhile, carbon fibers which are a fibrous carbon material are a paramagnetic material as a magnetic material and hardly absorb or reflect radio waves by magnetic interaction but are much lighter than magnetic materials. Therefore, if a radio wave shielding material can be manufactured from the carbon fibers, it is advantageous in terms of weight.

Carbon fibers cannot be used alone to form a member and must be contained in a matrix to be handled as a composite material. The composite material must be molded into an appropriate form for practical use. Molding the composite material is very difficult in most cases and various devices have been made so far.

The problem at this point is that the fibers have one-dimensional anisotropy. Especially in the case of long fibers, it is important that the influence of the anisotropy of the fibers should be eliminated to improve absorption characteristics. Therefore, it is considered that if the fiber network is formed at random three-dimensionally, one-dimensional nature derived from the fibrous state can be reduced, thereby providing a solution for supplying an efficient radio wave shielding material. If the network is formed at random three-dimensionally, the carbon fibers can exist as fibers not only in the in-plane direction but also in the thickness direction of a molded product and are very effective.

JP-A 5-275880 as a prior art relating to a radio wave shielding material which comprises carbon fibers discloses studies on use of a carbon material to reduce the weight of a radio wave shielding material comprising magnetic powders. JP-A 8-67544 proposes a method for shielding radio waves with a structure comprising cement as a matrix. Further, JP-A 10-25624 teaches a radio wave absorber comprising carbon long fibers.

DISCLOSURE OF THE INVENTION

It is an object of the present invention to provide a carbon fiber composite sheet which shows suitable thermal conductivity and improved three-dimensional thermal conductivity.

It is another obj ect of the present invention to provide a carbon fiber composite sheet which has the above thermal conductivity, improved adhesion to an exothermic body and high flexibility.

It is still another object of the present invention to provide use of the above carbon fiber composite sheet for thermal conductivity or radio wave shielding.

It is a further object of the present invention to provide a carbon fiber sheet for carbon fiber webs for use in the above carbon fiber composite sheet.

Other objects and advantages of the present invention will become apparent from the following description.

According to the present invention, firstly, the above objects and advantages of the present invention are attained by a carbon fiber composite sheet comprising a pitch-based carbon fiber web and a matrix resin, wherein carbon fibers constituting the pitch-based carbon fiber web have a crystallite size in the hexagonal net plane direction of 5 nm or more and a thermal conductivity in the thickness direction of 1 W/m·K or more.

According to the present invention, secondly, the above objects and advantages of the present invention are attained by the above carbon fiber composite sheet used for radio wave shielding.

According to the present invention, thirdly, the above objects and advantages of the present invention are attained by the above carbon fiber composite sheet for use as a heat conductor.

According to the present invention, in the fourth place, the above objects and advantages of the present invention are attained by a carbon fiber sheet for pitch-based carbon fiber webs for use in the above carbon fiber composite sheet, which has a content of pitch-based carbon fibers having a crystallite size in the hexagonal net plane direction of 5 nm or more of 80 wt% or more, a carbon content of 80 wt% or more, a thickness of 0.05 to 5 mm and a porosity of 50 to 90 vol%.

Brief Description of the Drawings

Fig. 1 is a diagram of a strip-like test sample for the evaluation of bending properties; and
Fig. 2 is a diagram showing a bending property evaluation method in the present invention.

BEST MODE FOR CARRYING OUT THE INVENTION

The raw material of the carbon fibers constituting the carbon fiber web used in the present invention is, for example, a condensation polycyclic hydrocarbon compound such as naphthalene or phenanthrene or a condensation heterocyclic compound such as petroleum pitch or coal pitch. Out of these, a condensation polycyclic hydrocarbon compound such as naphthalene or phenanthrene is preferred, and optically anisotropic pitch, that is, mesophase pitch is particularly preferred. They may be used alone or in combination of two or more. It is desired that mesophase pitch should be used alone to improve the thermal conductivity of the carbon fibers.

The softening point of the raw material pitch can be obtained by a Mettler method and is preferably 250 °C to 350 °C. When the softening point is lower than 250°C, fusion bonding between fibers or large thermal shrinkage occurs during stabilization. When the softening point is higher than 350°C, the thermal decomposition of the pitch occurs, whereby the pitch hardly becomes fibrous.

The raw material pitch is spun by a melt blow method and then stabilized and baked to become a carbon fiber web. Each step will be described hereinbelow.

Although a spinneret for spinning pitch fibers which are the raw material of 3-D random web-like carbon fibers is not limited to a particular shape, a nozzle having a ratio of the length of the nozzle hole to the diameter of the hole of preferably less than 3, more preferably less than 1.5 is used. The temperature of the nozzle at the time of spinning is not particularly limited and may be a temperature at which a stable spinning state can be maintained, that is, the viscosity of the pitch to be spun becomes 2 to 200 Pa·S, preferably 5 to 30 Pa·S.

The pitch fibers spun from the nozzle hole are changed into short fibers by blowing a gas heated at 100 to 350°C and having a linear velocity of 100 to 10,000 m/min to a position near a thinning point. The gas is, for example, air, nitrogen or argon, preferably air from the viewpoint of cost performance.

The pitch fibers are captured on a metal net belt to become a continuous web which is then crosslapped to become a web.

The thus obtained web composed of the pitch fibers is stabilized by a known method and baked at 1,000 to 3,500°C. Stabilization is carried out at 200 to 350°C by using air or a gas obtained by adding ozone, nitrogen dioxide, nitrogen, oxygen, iodine or bromine to air. It is desirably carried out in the air when safety and convenience are taken into consideration. The stabilized pitch fibers are baked in vacuum or an inert gas such as nitrogen, argon or krypton. They are preferably baked under normal pressure in inexpensive nitrogen. The baking temperature is preferably 2, 300 to 3, 500°C, more preferably 2, 500 to 3,500°C in order to increase the thermal conductivity of the carbon fibers. Baking in a graphite crucible is preferred because a physical or chemical function from the outside can be shut off. The graphite crucible is not limited to a particular size or shape if it can contain a predetermined amount of the stabilized web which will become the above raw material. However, it preferably has a lid to achieve high airtightness in order to prevent the carbon fiber web from being damaged by a reaction with an oxidizing gas or carbon steam in a furnace during baking or cooling.

The carbon fibers constituting the carbon fiber web used in the present invention have a crystallite size in the hexagonal net plane growth direction of 5 nm or more. The size of the crystallite in the hexagonal net plane growth direction can be obtained by a known method, that is, from a diffraction line from the (110) face of a carbon crystal obtained by an X-ray diffraction method. The reason why the size of the crystallite is important is that mainly a phonon conducts heat and a crystal transforms the phonon. The size of the crystallite is preferably 20 nm or more, more preferably 30 to 300 nm.

The carbon fibers constituting the carbon fiber web preferably have a fiber diameter of 1 to 20 $\mu$m. When the fiber diameter is smaller than 1 $\mu$m, the shape of the web may not be maintained with the result of low productivity. When the fiber diameter is larger than 20 $\mu$m, nonuniformity in the stabilizing step becomes large and fusion bonding occurs partially. It is more preferably 3 to 15 $\mu$m, much more preferably 5 to 12 $\mu$m. The CV value defined by the following equation is preferably 0.2 or less. It is more preferably 0.17 or less. When the CV value is larger than 0.2, the number of fibers having a diameter of more than 20 $\mu$m which cause a trouble by stabilization increases disadvantageously.

$$CV = \frac{S_1}{\overline{D}_1}$$

wherein $S_1$ is the degree of fiber diameter distribution and $\overline{D}_1$ is an average fiber diameter.

$S_1$ is obtained from the following equation.

$$S_1 = \sqrt{\frac{\sum_i (D - \overline{D_1})^2}{n^2}}$$

wherein D is the fiber diameter of each of an "n" number of fibers, $\overline{D}_1$ is the average value of the "n" number of fiber diameters, and n is the number of fibers.

The carbon fibers constituting the carbon fiber web preferably have a fiber length of 0.01 to 1,000 mm. When the fiber length is smaller than 0.01 mm, it is difficult to handle the fibers. When the fiber length is larger than 1,000 mm, the number of the interlaced fibers increases significantly, thereby making it difficult to handle them. The fiber length is more preferably 0.1 to 500 mm, much more preferably 3 to 300 mm.

The carbon fiber web used in the present invention may also be used as the following carbon fiber sheet in the composite sheet of the present invention.

The carbon fiber sheet is manufactured by fabricating web-like pitch fibers and further carrying out the following steps sequentially like the method of manufacturing the above carbon fiber web.

The thus obtained pitch fibers are stabilized by a known method and baked at 700 to 900°C. Stabilization is carried out at 200 to 350°C by using air or a gas obtained by adding ozone, nitrogen dioxide, nitrogen, oxygen, iodine or bromine to air. It is desirably carried out in the air when safety and convenience are taken into consideration. The stabilized pitch fibers are baked in vacuum or an inert gas such as nitrogen, argon or krypton. They are preferably baked under normal pressure in inexpensive nitrogen.

The pitch fibers which have been baked are milled into short fibers and optionally sieved to obtain a pitch-based carbon fiber precursor having a desired average fiber length.

For milling, a mill such as a pin mill, Victory mill, jet mill or high-speed rotary mill, or a cutter may be used. To mill the fibers efficiently, a method for cutting fibers in a direction perpendicular to their axes by turning a rotor having a blade at a high speed is suitable. The average fiber length of the pitch fibers obtained by milling is controlled by adjusting the revolution of the rotor and the angle of the blade.

As for sieving, the desired size can be achieved by combining sieves with different meshes.

The above carbon fibers are obtained by graphitizing the above pitch-based carbon fiber precursor which has undergone the above process in a non-oxidizing atmosphere.

The graphitization temperature is preferably 2,300 to 3,500°C, more preferably 2,500 to 3,500°C to increase the thermal conductivity of the carbon fibers.

Although graphitization is carried out on the milled pitch-based carbon fiber precursor, the pitch-based carbon fiber precursor may be processed into a sheet with papermaking in the presence of a binder and graphitized together with the binder.

The above carbon fiber sheet used in the present invention has a carbon content of 80 wt% or more, a thickness of 0.05 to 5 mm and a porosity of 50 to 90 vol%.

The carbon content is preferably 90 wt% or more. When the carbon content is lower than 80 wt%, the thermal conductivity of the carbon fiber sheet degrade disadvantageously.

The thickness of the carbon fiber sheet is preferably 0.1 to 3 mm. When the thickness is smaller than 0.05 mm, the handling properties and productivity lower and when the thickness is larger than 5 mm, the productivity of the carbon fiber reinforced composite material lowers disadvantageously.

The porosity of the carbon fiber sheet is preferably 50 to 80 vol%. Outside the above ranges, a handling problem may arise due to the deterioration of mechanical properties, or the impregnation of the carbon fiber reinforced composite material with a resin at the time of molding becomes unsatisfactory.

The above pitch-based carbon fibers which are the carbon fibers of the carbon fiber sheet have a crystallite size in the hexagonal net plane growth direction of 5 nm or more, preferably 20 nm or more, more preferably 30 nm or more.

The pitch-based carbon fibers preferably have an average fiber diameter of 1 to 20 $\mu$m, a ratio of the degree of filament diameter distribution to average fiber diameter (CV value) of 0.05 to 0.2 and a fiber length of 1 to 15 mm.

When the average fiber diameter is smaller than 1 $\mu$m, productivity and handling properties greatly lower disadvantageously. When the fiber diameter is larger than 20 $\mu$m, nonuniformity in the stabilization step becomes large and fusion bonding occurs partially. The average fiber diameter is more preferably 3 to 17 $\mu$m, much more preferably 5 to 15 $\mu$m.

The CV value is preferably 0.07 to 0.18. When the CV value is smaller than 0.05, the control of the fiber diameter becomes difficult with the result of low productivity. When the CV value is larger than 0.2, the shapes of the carbon fibers may change at the time of baking disadvantageously.

The average fiber length is preferably 1 to 15 mm. Outside this range, a homogenous sheet is hardly formed and a desired thermal conductivity is hardly obtained disadvantageously.

The true density of the pitch-based carbon fibers which greatly depends on the processing temperature is preferably 1. 5 to 2.5 g/cc. It is more preferably 1. 6 to 2.5 g/cc. The thermal conductivity in the fiber axial direction of the pitch-based carbon fibers is 200 W/(m·K) or more, more preferably 300 W/(m·K) or more.

The pitch-based carbon fiber sheet has a thermal conductivity in the thickness direction of preferably 3 W/ (m·K) or more, more preferably 5 W/(m·K) or more.

When the pitch-based carbon fiber sheet satisfies all the above ranges, it is excellent in thermal conductivity and handling properties.

The above carbon fiber sheet is obtained by papermaking the pitch-based carbon fibers in the presence of a binder.

The binder is at least one selected from fibrous, fibrid (fine film-like), pulp-like and particulate binders. The binder must be easily entangled with the pitch-based carbon fibers to improve papermaking-ability and may be a thermoplastic resin or a thermosetting resin.

The binder is preferably such that at least 1 wt% of its amount remains as a carbonaceous binder.

Examples of the above thermoplastic resin include polyamide, aramide, polyester, polypropylene, polyethylene and PVA.

Examples of the above thermosetting resin include polyimide resin, urethane resin, epoxy resin and phenolic resin.

The amount of the binder is preferably 1 to 20 wt%, more preferably 3 to 15 wt% based on the total weight of the pitch-based carbon fibers. Outside the above range, after processing into a sheet with papermaking, handling properties deteriorate disadvantageously.

To process the pitch-based carbon fibers into a sheet, a wet process in which the fibers are dispersed into a large amount of a dispersant and scooped up and a dry process in which, after fibers are dispersed into an air stream, thin films are formed by blowing this fiber dispersed air stream and joined together may be employed. When the dispersibility of the fibers and productivity are taken into account, the wet process is preferably employed.

The obtained sheet is optionally subjected to calendering or baking, and the binder is preferably selected according to these methods.

When calendering is carried out, a thermoplastic resin such as polyamide, aramide, polyester, polypropylene or polyethylene is preferably used and when baking is carried out, a resin having a relatively high carbon retention such as PVA, aramide or phenolic resin is preferably used.

Baking is carried out at a temperature of 1,300 to 3,000°C in an inert gas atmosphere, and the carbon content of the obtained pitch-based carbon fiber sheet is preferably 95 wt% or more.

The matrix resin used in the present invention is a thermosetting resin, a thermoplastic resin or a thermoplastic elastomer resin.

A polycarbonate, polyethylene terephthalate, polyethylene-2,6-naphthalene dicarboxylate, polyamide, polypropylene, polyethylene, polyepoxy ether ketone, polyphenylene sulfide or copolymer of each of these polymers may be used as the thermoplastic resin. Specific examples of the thermoplastic resin include polyethylene, polypropylene, ethylene-α-olefin copolymers such as ethylene-propylene copolymer, polymethylpentene, polyvinyl chloride, polyvinylidene chloride, polyvinyl acetate, ethylene-vinyl acetate copolymer, polyvinyl alcohols, polyacetals, fluororesins (such as polyvinylene fluoride and polytetrafluoroethylene), polyethylene terephthalate, polybutylene terephthalate, polyethylene naphthalate, polystyrene, polyacrylonitrile, styrene-acrylonitrile copolymer, ABS resin, polyphenylene ether (PPE) resin, modified PPE resin, aliphatic polyamides, aromatic polyamides, polyimides, polyamide-imides, plymethacrylic acids (polymethacrylates such as methyl polymethacrylate), polyacrylic acids, polycarbonates, polyphenylene sulfides, polysulfones, polyether sulfones, polyether nitriles, polyether ketones, polyketones, liquid crystal polymers and ionomers. These thermoplastic resins may be used alone or in combination of two or more. A polymer alloy of two or more thermoplastic resins may also be used.

The thermoplastic elastomer resin is preferably a polyester elastomer which is preferably a block copolymer composed of a hard segment and a soft segment. The melting point of the polyester elastomer is preferably 180 to 230 °C, more preferably 190 to 210 °C. The preferred elastic modulus of the polyester elastomer is 1,000 MPa or less. Commercially available products of the thermoplastic polyester-based elastomer resin include the TR-EKV, B4032AT, B4063AC and P4140DT of Teijin Chemicals Ltd. Out of these, P4140DT and B4032AT whose water absorptivity is suppressed are preferred.

To improve the stability of the thermoplastic polyester-based elastomer resin, a stabilizer may be added.

Examples of the thermosetting resin include epoxy resin, phenolic resin, silicone resin, polyurethane resin, polyimide resin, thermosetting polyphenylene ether resin and thermosetting modified polyphenylene ether resin. They may be used alone or in combination of two or more. Further, a mixture of a thermoplastic resin and a thermosetting resin may be used as the matrix resin in order to develop desired physical properties for a carbon fiber reinforced plastic molded product.

The carbon fiber composite sheet of the present invention may be manufactured by a conventionally known method. Examples of the method of manufacturing the molded product include injection molding, press molding, calender molding, extrusion molding, cast molding and blow molding. Out of these, press molding is preferred. In press molding, the carbon fiber web and a thermoplastic resin are laminated together, heated at a temperature higher than the melting temperature of the thermoplastic resin and molded by applying high pressure. Before molding, the surface of the carbon fiber web may be modified by oxidation such as electrolytic oxidation or treatment with a coupling agent or a sizing agent. Alternatively, a metal or ceramic film may be formed on the surface by physical deposition such as electroless plating, electrolytic plating, vacuum deposition, sputtering or ion plating, chemical deposition, coating, immersion or mechanochemical process for fixing fine particles mechanically.

Although the mixing ratio of the carbon fiber web to the thermoplastic polymer resin is not particularly limited, carbon fibers are desirably contained in an amount of preferably 10 to 90 vol%, more preferably 10 to 85 vol% after molding in order to improve thermal conductivity. It is most preferably 20 to 65 vol%. The thickness of the carbon fiber composite sheet may be freely designed according to its application purpose but preferably 0.2 to 10 mm in order to improve molding yield. When the thickness is smaller than 0.2 mm, uniform molding becomes difficult and when the thickness is larger than 10 mm, it is difficult to control thickness nonuniformity.

The molding method for obtaining a carbon fiber reinforced composite by using the above carbon fiber sheet is not particularly limited and may be injection molding, press molding, calender molding, extrusion molding, cast molding or blow molding. The following two methods may also be used.

As an illustrative method, the matrix resin which is liquid at normal temperature or increased temperature is introduced into the pitch-based carbon fiber sheet fed into a metal mold in advance by RIM or RTM and solidified or cured to obtain a carbon fiber reinforced composite sheet.

Alternatively, as another method, the pitch-based carbon fiber sheet and the matrix resin are fed into the metal mold so that the matrix resin is molten and impregnated into the sheet to obtain the carbon fiber reinforced composite sheet.

In the latter method, the matrix resin is preferably in a sheet form or the like so that it can be easily fed into the metal mold and also impregnated under vacuum and increased pressure from the viewpoints of degassing and impregnation properties.

The pitch-based carbon fiber sheet can be adhered with a sizing agent after its surface is modified.

The surface of the carbon fiber sheet may be modified by oxidation such as electrolytic oxidation or treatment with a coupling agent or a sizing agent. Alternatively, a metal or ceramic film may be formed on the surface by physical deposition such as electroless plating, electrolytic plating, vacuum deposition, sputtering or ion plating, chemical deposition, coating, immersion or mechanochemical process for fixing fine particles mechanically.

The sizing agent is used in an amount of preferably 0.1 to 15 wt%, more preferably 0.4 to 7.5 wt% based on the pitch-based carbon fiber sheet. Any commonly used sizing agent may be used, as exemplified by epoxy compounds, water-soluble polyamide compounds, saturated polyesters, unsaturated polyesters, vinyl acetate, water, alcohols and glycols. They may be used alone or in combination.

Although the thermal conductivity of the carbon fiber of the present invention can be measured by a known method, it is preferably measured by a laser flash method so as to improve the thermal conductivity in the thickness direction of the carbon fiber composite sheet. In the laser flash method, specific heat capacity Cp (J/gK) and thermal diffusivity $\alpha$ (cm$^2$/sec) are measured, thermal conductivity $\lambda$ (W/cmK) is obtained from density $\rho$ (g/cc) measured separately based on the equation $\lambda = \alpha \cdot Cp \cdot \rho$, and the unit is changed to obtain the thermal conductivity of the carbon fiber. In general, the thermal conductivity of the carbon fiber itself is several hundreds of W/(m·K) but the thermal conductivity of a molded product obtained from the carbon fiber sharply drops due to the generation of defects, the inclusion of air and the unexpected formation of voids. Therefore, it is considered that the thermal conductivity of the carbon fiber composite sheet hardly exceeds 1 W/(m· K) substantially. However, in the present invention, this is solved by using 3-D random web-like carbon fibers and the thermal conductivity of the carbon fiber composite sheet is increased to 1 W/(m·K) or more. It is more preferably 2 W/ (m· K) or more, much more preferably 5 W/(m·K) or more.

The radio wave shielding of the carbon fiber composite sheet of the present invention can be measured by a known method. The shield factor of radio waves generated from electronic equipment can be measured by a strip line method. The carbon fiber composite sheet has a large shield factor of more than 10 dB at 1 to 10 GHz, especially 1 to 3 GHz. When the shield factor is larger than 10 dB, it can be considered that the carbon fiber composite sheet has certain ability. The shield factor is more preferably 12 dB or more, much more preferably 20 dB or more.

The carbon fiber composite sheet obtained as described above is put into a metal mold having a predetermined shape, heated at a temperature higher than the softening point temperature of the thermoplastic resin and press molded into a molded product. The molded product manufactured as described above can be advantageously used for thermal management application. Stated more specifically, the molded product is used as a radiator member, thermal conduction member or a constituent material thereof for diffusing heat generated from electronic parts such as semiconductor devices, power sources and light sources to the outside effectively. More specifically, it is formed into a desired shape capable of forming a metal mold and interposed between a heat generating member such as a semiconductor device and a radiator member such as a radiator, or molded into a radiator plate, semiconductor package part, heat sink, heat spreader, die pad, printed wiring board, cooling fan part, heat pipe or housing.

Examples

The following examples are provided but are in no way to be taken as limiting of the present invention.
Values in Examples were obtained in accordance with the following methods.

(1) The diameter of the carbon fiber web was obtained by taking photos of 10 different view fields of the fibers after baking with a scanning electron microscope at a magnification of 800.
(2) The fiber lengths of the carbon fiber web and the carbon short fiber were measured with a length meter by extracting fibers after baking.
(3) The thermal conductivity of the carbon fiber was obtained from the following equation (1) showing the relationship between thermal conductivity and electric resistivity disclosed by JP-A 11-117143 by measuring the resistivity of yarn after baking:

$$K = 1272.4/ER - 49.4 \qquad (1)$$

wherein K is the thermal conductivity W/(m·K) of the carbon fiber and ER is the electric resistivity $\mu\Omega$m of the carbon fiber.
(4) The thermal conductivity of a molded product was obtained by the laser flash method.
(5) The crystal size of the carbon fiber web was obtained by measuring reflection from the (110) face which appears in X-ray diffraction in accordance with the GAKUSHIN method.
(6) The radio wave shielding properties in the neighborhood field were measured by using a strip line method

The following items (7) to (8) are applied to a composite sheet comprising a thermoplastic resin elastomer as the matrix resin.

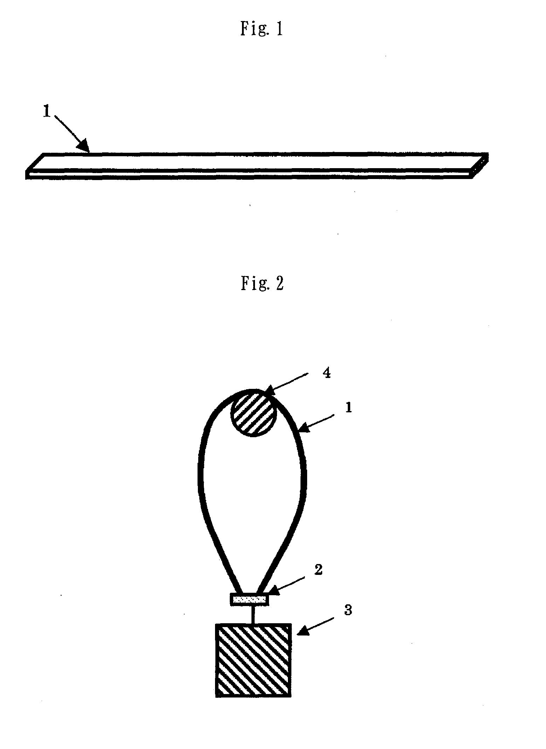

(7) The thermal conductivity of the carbon fiber composite sheet was obtained by a probe method using the QTM-500 of Kyoto Denshi Co., Ltd.
(8) As for bending properties, whether both ends in the longitudinal direction of a strip-like test sample (1 in Fig. 1 and Fig. 2) measuring 160 mm x 10 mm prepared from a carbon fiber composite sheet having a thickness of 0.5 mm could be connected together by a clip (2 in Fig. 2) and further whether the sample could be caught by a rod having a diameter of 15 mm (4 in Fig. 2) for 1 minute while a load of 100 gf (3 in Fig. 2) was applied to the connected ends were checked. When the ends of the strip-like test sample could be connected together, the bending properties were evaluated as satisfactory and when rupture did not occur by catching the sample by the rod having a diameter of 15 mm under a load, the bending properties were evaluated as excellent (Fig. 2 shows this state).

When the ends in the longitudinal direction of the strip-like test sample could not be connected together and when rupture occurred under a load, the bending properties were evaluated as bad.

Example 1

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.
This 3-D random web was heated in the air from 170 to 295°C at an average temperature elevation rate of 7°C/min to be stabilized. The stabilized 3-D random web was baked at 2,300°C. The baked 3-D random web-like carbon fibers had an average fiber diameter of 8.5 $\mu$m and a CV of 0.15. They had an average fiber length of 40 mm and a crystallite size of 26 nm.
A maleic acid-modified polypropylene film manufactured by Sanyo Chemical Industries, Ltd. was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fiber sheet had an electric conductivity of 4.5 x $10^{-4}$ $\Omega \cdot$ cm. Its thermal conductivity was 233 W/(m·K). When the thermal conductivity of the molded carbon fiber composite sheet was measured, it was 1.5 W/(m·K). The sheet had a density of 1.3 g/cc, and when its radio wave shield factor was measured by the strip line method, it was 15 dB at 2.0 GHz.

Example 2

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.
This 3-D random web was heated in the air from 170 to 295°C at an average temperature elevation rate of 7°C/min to be stabilized. The stabilized 3-D random web was baked at 3,000°C. The baked 3-D random web-like carbon fibers had an average fiber diameter of 8 $\mu$m and a CV of 0.16. They had an average fiber length of 30 mm and a crystallite size of 45 nm.
A maleic acid-modified polypropylene film manufactured by Sanyo Chemical Industries, Ltd. was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fiber sheet had an electric conductivity of 2 x $10^{-4}$ $\Omega \cdot$cm. Its thermal conductivity was 587 W/(m·K). When the thermal conductivity of the molded carbon fiber composite sheet was measured, it was 4.0 W/ (m·K). The sheet had a density of 1.5 g/cc, and when its radio wave shield factor was measured by the strip line method, it was 19 dB at 2.5 GHz.

Example 3

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$. This 3-D random web was heated in the air from 170 to 295°C at an average temperature elevation rate of 7°C/min to be stabilized. The stabilized 3-D random web was baked at 2,300°C. The baked 3-D random web-like carbon fibers had an average fiber diameter of 8.5 $\mu$m and a CV of 0.17. They had an average fiber length of 40 mm and a crystallite size of 18 nm.
A polycarbonate film manufactured by Teij in Chemicals Ltd. was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fibers had an electric conductivity of 4.5 x $10^{-4}$ $\Omega \cdot$cm and a thermal conductivity of 233 W/(m·K). When the thermal conductivity of the molded carbon fiber composite sheet was measured, it was 1.3 W/(m·K). The sheet had a density of 1.4 g/cc and a shield factor of 20 dB at 2.5 GHz.

Example 4

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$. This 3-D random web was heated in the air from 170 to 295 °C at an average temperature elevation rate of 7°C/min to be stabilized. This stabilized 3-D random web was baked at 3,000°C. The baked 3-D random web-like carbon fibers had an average fiber diameter of 8 $\mu$m and a CV of 0.16. They had an average fiber length of 30 mm and a crystallite size of 45 nm.

A polycarbonate film manufactured by Teij in Chemicals Ltd. was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fibers had an electric conductivity of $2 \times 10^{-4}$ $\Omega \cdot$cm and a thermal conductivity of 587 W/(m·K). When the thermal conductivity of the molded carbon fiber composite sheet was measured, it was 3.8 W/(m·K). The sheet had a density of 1.5 g/cc and a shield factor of 20 dB at 2.4 GHz.

Example 5

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.

This 3-D random web was heated in the air from 170 to 295°C at an average temperature elevation rate of 7°C/min to be stabilized. This stabilized 3-D random web was baked at 3, 000°C. The baked 3-D random web-like carbon fibers had an average fiber diameter of 8 $\mu$m and a CV of 0.16. They had an average fiber length of 30 mm and a crystallite size of 45 nm.

A film manufactured by polymerizing the lactide of Tokyo Kasei Co., Ltd. to obtain polylactic acid and melt extruding the polylactic acid was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fibers had an electric conductivity of $2 \times 10^{-4}$ $\Omega \cdot$cm and a thermal conductivity of 587 W/(m·K). When the thermal conductivity of the molded carbon fiber composite sheet was measured, it was 3.1 W/(m·K). The sheet had a density of 1. 7 g/cc and a shield factor of 18 dB at 2.6 GHz.

Comparative Example 1

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.

This 3-D random web was heated in the air from 170 to 295°C at an average temperature elevation rate of 7°C/min to be stabilized. This stabilized 3-D random web was baked at 800°C. The baked 3-D random web-like carbon fibers had an average fiber diameter of 9 $\mu$m and a CV of 0.18. They had an average fiber length of 40 mm and a crystallite size of 3 nm.

A maleic acid-modified polypropylene film manufactured by Sanyo Chemical Industries, Ltd. was used as a thermoplastic polymer resin, the volume ratio of the 3-D random web-like carbon fibers to a molded product was set to 30 %, and press molding was carried out by a vacuum press manufactured by Kitagawa Seiki Co., Ltd. using a metal mold having an inside measure of 650 mm to obtain a molded product having a thickness of 1 mm. The 3-D random web-like carbon fibers had an electric conductivity of $15 \times 10^{-4}$ $\Omega \cdot$cm and a thermal conductivity of 35 W/(m·K). When the thermal conductivity of the molded carbon fiber composite sheet was measured, it was 0.3 W/(m·K). Although the thermal conductivity of the sheet was higher than that of the thermoplastic resin alone, it was lower than that of a high-temperature baked product. The sheet had a density of 1.2 g/cc and a shield factor of 8 dB at 2.5 GHz.

Example 6

The carbon fiber composite sheet manufactured in Example 3 was heated at 190°C which is the softening point temperature of a polycarbonate which is a thermoplastic polymer resin to be molded to obtain a molded product. The moldability was satisfactory. A 20 g weight heated at 70°C was placed on this molded product to heat it for 150 seconds to raise the temperature of the carbon fiber composite sheet to about 70°C. When the weigh was removed and the molded product was left to be cooled, its temperature dropped to 20°C in 60 seconds.

Comparative Example 2

A polycarbonate resin alone was molded to obtain a molded product in place of the carbon fiber composite sheet in Example 6. The moldability was satisfactory. A 20 g weight heated at 70°C was placed on this molded product to heat it for 150 seconds to raise the temperature of the carbon polycarbonate resin to about 70°C. When the weigh was removed and the molded product was left to be cooled, its temperature dropped to 50°C in 60 seconds. Radiation was worse than that of a carbon composite sheet.

Example 7

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.

This 3-D random web was heated in the air from 170 to 295°C at an average temperature elevation rate of 7°C/min to be stabilized. This stabilized 3-D random web was baked at 2,300°C. The baked 3-D random web-like carbon fibers had an average fiber diameter of 8.5 $\mu$m and a CV of 0.15. They had an average fiber length of 40 mm and a crystallite size in the hexagonal net plane growth direction of 26 nm.

The B4032AT of Teijin Chemicals Ltd. was used as a thermoplastic polyester-based elastomer resin, the volume ratio of the 3-D random web-like carbon fiber assembly to a molded product was set to 30 %, and press molding was carried out by a vacuum press manufactured by Kitagawa Seiki Co., Ltd. using a metal mold having an inside measure of 650 mm to obtain a molded product having a thickness of 0.5 mm.

When the thermal conductivity of the molded carbon fiber composite sheet was measured, it was 3 W/(m·K). Its bending properties were extremely good.

Example 8

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5,000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.

This 3-D random web was heated in the air from 170 to 295°C at an average temperature elevation rate of 7°C/min to be stabilized. This stabilized 3-D random web was baked at 2,300°C. The baked 3-D random web-like carbon fiber assembly had an average fiber diameter of 8.5 $\mu$m and a CV of 0.16. It had an average fiber length of 40 mm and a crystallite size in the hexagonal net plane growth direction of 26 nm.

The B4032AT of Teijin Chemicals Ltd. was used as a thermoplastic polyester-based elastomer resin, the volume ratio of the 3-D random web-like carbon fibers to a molded product was set to 40 %, and press molding was carried out by a vacuum press manufactured by Kitagawa Seiki Co., Ltd. using a metal mold having an inside measure of 650 mm to obtain a molded product having a thickness of 0.5 mm.

When the thermal conductivity of the molded carbon fiber composite sheet was measured, it was 6 W/(m·K). Its bending properties were extremely good.

Example 9

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5,000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$. This 3-D random web was heated in the air from 170 to 295 °C at an average temperature elevation rate of 7°C/min to be stabilized. This stabilized 3-D random web was baked at 3,000°C. The baked 3-D random web-like carbon fibers had an average fiber diameter of 8 $\mu$m and a CV of 0.16. They had an average fiber length of 30 mm and a crystallite size in the hexagonal net plane growth direction of 45 nm.

The B4032AT of Teijin Chemicals Ltd. was used as a thermoplastic polyester-based elastomer resin, the volume ratio of the 3-D random web-like carbon fiber assembly to a molded product was set to 30 %, and press molding was carried out by a vacuum press manufactured by Kitagawa Seiki Co., Ltd. using a metal mold having an inside measure of 650 mm to obtain a molded product having a thickness of 0.5 mm.

When the thermal conductivity of the molded carbon fiber composite sheet was measured, it was 7 W/(m·K). Its bending properties were extremely good.

Example 10

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$. This 3-D random web was heated in the air from 170 to 295°C at an average temperature elevation rate of 7°C/min to be stabilized. This stabilized 3-D random web was baked at 3,000°C. The baked 3-D random web-like carbon fiber assembly had an average fiber diameter of 8 $\mu$m and a CV of 0.16. It had an average fiber length of 30 mm and a crystallite size of 45 nm.

The B4032AT of Teijin Chemicals Ltd. was used as a thermoplastic polyester-based elastomer resin, the volume ratio of the 3-D random web-like carbon fiber assembly to a molded product was set to 40 %, and press molding was carried out by a vacuum press manufactured by Kitagawa Seiki Co., Ltd. using a metal mold having an inside measure of 650 mm to obtain a molded product having a thickness of 0.5 mm. When the thermal conductivity of the molded carbon fiber composite sheet was measured, it was 12 W/(m·K). Its bending properties were extremely good.

Example 11

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$.

This 3-D random web was heated in the air from 170 to 295°C at an average temperature elevation rate of 7°C/min to be stabilized. This stabilized 3-D random web was baked at 2,300°C. The baked 3-D random web-like carbon fiber assembly had an average fiber diameter of 8.5 $\mu$m and a CV of 0.16. It had an average fiber length of 40 mm and a crystallite size of 26 nm.

The TR-EKV of Teijin Chemicals Ltd. was used as a thermoplastic polyester-based elastomer resin, the volume ratio of the 3-D random web-like carbon fiber assembly to a molded product was set to 30%, and press molding was carried out by a vacuum press manufactured by Kitagawa Seiki Co., Ltd. using a metal mold having an inside measure of 650 mm to obtain a molded product having a thickness of 0.5 mm. When the thermal conductivity of the molded carbon fiber composite sheet was measured, it was 2.5 W/(m·K). Its bending properties were extremely good.

Reference Example 1

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5, 000 m/min to draw the molten pitch so as to manufacture pitch-based short fibers having an average diameter of 10 $\mu$m. The spun fibers were collected on a belt to obtain a web which was then crosslapped to manufacture a 3-D random web composed of pitch-based short fibers having a weight of 250 g/m$^2$. This 3-D random web was heated in the air from 170 to 295°C at an average temperature elevation rate of 7°C/min to be stabilized. This stabilized 3-D random web was baked at 3,000°C. The baked 3-D random web-like carbon fiber assembly had an average fiber diameter of 8 $\mu$m and a CV of 0.16. It had an average fiber length of 30 mm and a crystallite size of 45 nm.

The B4032AT of Teijin Chemicals Ltd. was used as a thermoplastic polyester-based elastomer resin, the volume ratio of the 3-D random web-like carbon fiber assembly to a molded product was set to 55 %, and press molding was carried out by a vacuum press manufactured by Kitagawa Seiki Co., Ltd. using a metal mold having an inside measure of 650 mm to obtain a molded product having a thickness of 0.5 mm. When the thermal conductivity of the molded carbon fiber composite sheet was measured, it was 15.0 W/(m·K). Its bending properties were good.

Example 12

A 20 g weight heated at 70°C was placed on the carbon fiber composite sheet manufactured in Example 8 to heat it for 150 seconds to raise the temperature of the carbon fiber composite sheet to about 70°C. When the weigh was removed and the sheet was left to be cooled, its temperature dropped to 20°C in 60 seconds. It was found that it had a large radiation effect.

Comparative Example 3

A 20 g weight heated at 70°C was placed on a thermoplastic polyester-based elastomer resin alone in place of the carbon fiber composite sheet in Example 12 to heat it for 150 seconds to raise the temperature of the thermoplastic polyester-based elastomer resin to about 70°C. When the weigh was removed and the resin was left to be cooled, its temperature dropped to 50°C in 60 seconds. Radiation was lower than that of the carbon composite sheet.

Example 13

Pitch composed of a condensation polycyclic hydrocarbon compound was used as the main raw material. The ratio of the optical anisotropy of this pitch was 100 % and its softening point was 284°C. A cap having a hole with a diameter of 0.2 mm was used, and heated air was ejected from a slit at a linear velocity of 5, 000 m/min to draw the molten pitch so as to manufacture pitch-based short fibers having an average diameter of 13 $\mu$m. The spun fibers were collected on a belt to obtain a web which was then crosslapped to manufacture web-like pitch fibers having a weight of 250 g/m$^2$.

The web-like pitch fibers were heated in the air from 170 to 310°C at an average temperature elevation rate of 5°C/min to be stabilized. This stabilized web-like pitch fibers were baked at 700°C, milled into short fibers and baked at 3,000°C to obtain pitch-based carbon fibers. The pitch-based carbon fibers had an average fiber diameter of 11 $\mu$m and a CV of 0.12. They had an average fiber length of 8 mm and a crystallite size in the hexagonal net plane growth direction of 46 nm. The pitch-based carbon fibers had a thermal conductivity in the fiber axial direction of 590 W/ (m· K). The pitch-based carbon fibers had a true density of 2.1 g/cc.

90 parts by weight of the pitch-based carbon fibers and 10 parts by weight of PVA fibers having an average fiber length of 5 mm as a binder were processed into a sheet with papermaking which was then baked at 1,500°C in a nitrogen atmosphere to obtain a pitch-based carbon fiber sheet.

The pitch-based carbon fiber sheet had a carbon content of 99 wt%, a thickness of 1.2 mm and a porosity of 85 vol%.

A maleic acid-modified polypropylene film manufactured by Sanyo Chemical Industries, Ltd. was used as a matrix resin, the volume ratio of the pitch-based carbon fiber sheet as a reinforcement to a molded product was set to 30 %, and press molding was carried out by a vacuum press manufactured by Kitagawa Seiki Co., Ltd. using a metal mold having an inside measure of 200 mm to obtain a molded product having a thickness of 1 mm. When the thermal conductivity in the thickness direction of the molded carbon fiber reinforced composite sheet was measured, it was 4.5 W/(m· K) .

Example 14

Pitch composed of a condensation polycyclic hydrocarbon compound was used as the main raw material. The ratio of the optical anisotropy of this pitch was 100 % and its softening point was 284°C. A cap having a hole with a diameter of 0.2 mm was used, and heated air was ejected from a slit at a linear velocity of 5, 000 m/min to draw the molten pitch so as to manufacture pitch-based short fibers having an average diameter of 13 $\mu$m. The spun short fibers were collected on a belt to obtain a web which was then crosslapped to manufacture web-like pitch fibers having a weight of 255 g/m$^2$.

The web-like pitch fibers were heated in the air from 170 to 305°C at an average temperature elevation rate of 5°C/min to be stabilized. This stabilized web-like pitch fibers were baked at 700°C, milled into short fibers and baked at 2,900°C to obtain pitch-based carbon fibers. The pitch-based carbon fibers had an average fiber diameter of 11 $\mu$m and a CV of 0.11. They had an average fiber length of 8 mm and a crystallite size in the hexagonal net plane growth direction of 42 nm. They had a thermal conductivity in the fiber axial direction of 510 W/(m·K) and a true density of 2.1 g/cc.

90 parts by weight of the pitch-based carbon fibers and 10 parts by weight of polyethylene terephthalate fibers having an average fiber length of 10 mm as a binder were processed into a sheet with papermaking which was then calendered at 280°C to obtain a pitch-based carbon fiber sheet.

The pitch-based carbon fiber sheet had a carbon content of 90 wt%, a thickness of 1.2 mm and a porosity of 70 vol%.

A polycarbonate film (trade name: Panlite) was used as a matrix resin, the volume ratio of the pitch-based carbon fiber reinforcement to a molded product was set to 35 %, and press molding was carried out by a vacuum press manufactured by Kitagawa Seiki Co. , Ltd. using a metal mold having an inside measure of 200 mm to obtain a molded product having a thickness of 1 mm. When the thermal conductivity in the thickness direction of the molded carbon fiber reinforced composite sheet was measured, it was 4.3 W/(m·K).

Comparative Example 4

Pitch composed of a condensation polycyclic hydrocarbon compound was used as the main raw material. The ratio of the optical anisotropy of this pitch was 100 % and its softening point was 285°C. A cap having a hole with a diameter of 0.2 mm was used, and heated air was ejected from a slit at a linear velocity of 5,000 m/min to draw the molten pitch so as to manufacture pitch-based short fibers having an average diameter of 10 $\mu$m. The spun fibers were collected on a belt to obtain a web which was then crosslapped to manufacture a pitch fiber web having a 3-D random shape and a weight of 250 g/m$^2$.

The pitch fiber web was heated in the air from 170 to 295°C at an average temperature elevation rate of 7°C/min to be stabilized. This stabilized 3-D random web was baked at 800°C. The pitch-based carbon fibers constituting the baked pitch-based carbon fiber web had an average fiber diameter of 9 $\mu$m and a CV of 0.18. They had an average fiber length of 40 mm and a crystallite size in the hexagonal net plane growth direction of 3 nm. They had a thermal conductivity in the fiber axial direction of 35 W/(m·K).

70 parts by weight of the pitch-based carbon fibers and 10 parts by weight of PVA fibers having an average fiber length of 5 mm (trade name: Vinylon) as a binder were processed into a sheet with papermaking to obtain a pitch-based carbon fiber sheet.

The pitch-based carbon fiber sheet had a carbon content of 65 wt%, a thickness of 1.5 mm and a porosity of 80 vol%.

A maleic acid-modified polypropylene film manufactured by Sanyo Chemical Industries, Ltd. was used as a matrix resin, the volume ratio of the pitch-based carbon fiber sheet as a reinforcement to a molded product was set to 30 %, and press molding was carried out by a vacuum press manufactured by Kitagawa Seiki Co., Ltd. using a metal mold having an inside measure of 200 mm to obtain a molded product having a thickness of 1 mm. When the thermal conductivity in the thickness direction of the molded carbon fiber reinforced composite material was measured, it was less than 1 W/(m·K) which is small.

Comparative Example 5

A maleic acid-modified polypropylene resin alone was molded to obtain a molded product without using the pitch-based carbon fiber sheet in Example 1. When the thermal conductivity in the thickness direction of this molded product was measured, it was less than 1 W/(m·K).

**Claims**

1. A carbon fiber composite sheet comprising a pitch-based carbon fiber web and a matrix resin, wherein carbon fibers constituting the pitch-based carbon fiber web have a crystallite size in the hexagonal net plane direction of 5 nm or more and a thermal conductivity in the thickness direction of 1 W/m·K or more.

2. The carbon fiber composite sheet according to claim 1, wherein the amount of the matrix resin is 10 to 80 vol% of the carbon fiber composite sheet.

3. The composite sheet according to claim 1, wherein carbon fibers constituting the pitch-based carbon fiber web have a fiber diameter of 1 to 20 $\mu$m and a fiber length of 0.01 to 1,000 mm.

4. The composite sheet according to claim 1, wherein the matrix resin is a thermoplastic resin or a thermoplastic elastomer resin.

5. The composite sheet according to claim 4, wherein the thermoplastic resin is selected from polycarbonate, polyethylene terephthalate, polyethylene-2,6-naphthalene dicarboxylate, polyamide, polypropylene, polyethylene, polyepoxy ether ketone, polyphenylene sulfide or copolymers of each of these polymers.

6. The composite sheet according to claim 4, wherein the thermoplastic elastomer resin is a polyester elastomer.

7. The composite sheet according to claim 6, wherein the polyester elastomer is a block copolymer composed of a hard segment and a soft segment.

8. The composite sheet according to claim 6 or 7 which does not break in a bending test which is made on a test sample having a length of 160 mm and a width of 10 mm with a rod having a diameter of 15 mm under a load of 100 gf for 1 minute.

9. The composite sheet according to any one of claims 1 to 8 which is used for radio shielding.

10. The composite sheet according to claim 9 which reflects 1 to 10 GHz radio waves in the neighboring field at 10 dB or more.

11. The composite sheet according to any one of claims 1 to 8 which is used as a heat conductor.

12. A radiator plate for electronic parts which is composed of the composite sheet of claim 11.

13. A heat exchanger which is composed of the composite sheet of claim 11.

14. A carbon fiber sheet for pitch-based carbon fiber webs for use in the carbon fiber composite sheet of claim 1, which has a content of pitch-based carbon fibers having a crystallite size in the hexagonal net plane direction of 5 nm or more of 80 wt% or more, a carbon content of 80 wt% or more, a thickness of 0.05 to 5 mm and a porosity of 50 to 90 vol%.

15. The carbon fiber sheet according to claim 14, wherein the pitch-based carbon fibers have an average fiber diameter of 1 to 20 $\mu$m, a ratio of the degree of filament diameter distribution to average fiber diameter of 0.05 to 0.2 and a fiber length of 1 to 15 mm.

16. The carbon fiber sheet according to claim 14, wherein the pitch-based carbon fibers have a true density of 1.5 to 2.5 g/cc and a thermal conductivity in the fiber axial direction of 200 W/(m·K) or more.

17. The carbon fiber sheet according to claim 14 which has a thermal conductivity in the thickness direction of 3 W/ (m·K) or more.

18. A method of manufacturing a carbon fiber sheet for pitch-based carbon fiber webs, which comprises manufacturing wet non-woven cloth from pitch-based carbon fibers in the presence of a binder in accordance with a papermaking method to obtain a sheet having a carbon content of 80 wt%, a thickness of 0.05 to 5 mm and a porosity of 50 to 90 vol%.

19. The method of manufacturing a carbon fiber sheet according to claim 18, wherein the wet non-woven cloth obtained by using a binder resulting carbon residue of at least 1 wt% based on the amount of the binder in accordance with the papermaking method is baked at 1,300 to 3,000°C in an inert gas atmosphere.

20. A method of manufacturing a carbon fiber composite sheet, comprising impregnating the carbon fiber sheet of claim 14 with a matrix resin.

21. The method of manufacturing a composite sheet according to claim 20, wherein impregnation is carried out under vacuum and increased pressure.



Fig. 1

Fig. 2

### INTERNATIONAL SEARCH REPORT

| International application No. |
| --- |
| PCT/JP2006/308370 |

| A. CLASSIFICATION OF SUBJECT MATTER |
| --- |
| *D04H3/00*(2006.01), *D04H3/16*(2006.01), *D01F9/145*(2006.01), *D21H13/50*(2006.01), *C08J5/04*(2006.01) |

According to International Patent Classification (IPC) or to both national classification and IPC

| B. FIELDS SEARCHED |
| --- |
| Minimum documentation searched (classification system followed by classification symbols)<br>D04H1/00-18/00, D01F9/08-9/32, B29B11/16, B29B15/08-15/14, D21H11/00-27/42, C08J5/04-5/10, C08J5/24 |

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| X<br><br>Y | JP 2002-285457 A  (Osaka Gas Co., Ltd.),<br>03 October, 2002 (03.10.02),<br>Claims; Par. Nos. [0016], [0028], [0041], [0044] to [0046]<br>(Family: none) | 1-5,14-17, 20<br><br>1-17,21 |
| Y | JP 2002-295787 A  (Kawasaki Heavy Industries, Ltd.),<br>09 October, 2002 (09.10.02),<br>Claims; examples; Par. No. [0019]<br>(Family: none) | 1-17,21 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 July, 2006 (07.07.06) | Date of mailing of the international search report<br>18 July, 2006 (18.07.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/308370 |

C (Continuation). DOCUMENTS CONSIDERED TO BE RELEVANT

| Category* | Citation of document, with indication, where appropriate, of the relevant passages | Relevant to claim No. |
| --- | --- | --- |
| X<br>Y | JP 2004-27435 A (Toho Tenakkusu Kabushiki Kaisha),<br>29 January, 2004 (29.01.04),<br>Claims 1, 2, 4; Par. Nos. [0001], [0047], [0054]<br>(Family: none) | 18,19<br>1-13 |
| Y | JP 2000-281905 A (Teijin Kasei Kabushiki Kaisha),<br>10 October, 2000 (10.10.00),<br>Par. Nos. [0018], [0028]<br>(Family: none) | 6-8 |
| Y | JP 5-275880 A (Kansai Paint Co., Ltd.),<br>22 October, 1993 (22.10.93),<br>Full text<br>(Family: none) | 9,10 |
| Y | JP 2004-314315 A (Toray Industries, Inc.),<br>11 November, 2004 (11.11.04),<br>Claims<br>(Family: none) | 21 |

Form PCT/ISA/210 (continuation of second sheet) (April 2005)

**EP 1 876 276 A1**

## REFERENCES CITED IN THE DESCRIPTION

### Patent documents cited in the description

- JP 5017593 A
- JP 2242919 A
- JP 5275880 A
- JP 8067544 A
- JP 10025624 A
- JP 11117143 A